# EUROPEAN PATENT APPLICATION

(11) **EP 2 259 430 A1**
(43) Date of publication of application: **08.12.2010**
(21) Application number: 10163912.8
(22) Date of filing: 26.05.2010
(51) Int. Cl.: H03K 19/00, G01R 31/3185, G06F 1/32

(54) **Semiconductor integrated circuit and method of saving and recovering its internal state.**

(30) Priority: 04.06.2009 JP 2009135085
(71) Applicant: Renesas Electronics Corporation, Nakahara-ku Kawasaki Kanagawa 211-8668 (JP)
(72) Inventor: Kawasaki, Tatsuya, Kawasaki Kanagawa 211-8668 (JP); Kunie, Shuichi, Kawasaki Kanagawa 211-8668 (JP); Sasaki,Tsuneki, Kawasaki Kanagawa 211-8668 (JP)
(74) Representative: Betten & Resch

(57) **Abstract**

A semiconductor integrated circuit includes; a first circuit; and a second circuit configured to control supply of a first power to the first circuit. The first circuit includes: a third circuit comprising a group of flip-flops, whose internal state is erased in response to stop of the supply of the first power; and a fourth circuit in which an internal state of the fourth circuit is saved in retention flip-flops before the supply of the first power is stopped and recovered from the retention flip-flops in response to restart of the supply of the first power.

## Description

### Technical Field

The present invention relates to a semiconductor integrated circuit, and a method of saving and recovering an internal state of the semiconductor integrated circuit.

### Background Art

In recent years, a semiconductor integrated circuit having a low consumption power mode such as a standby mode and a resume function is highlighted. Usually, when a power supply is stopped in a semiconductor integrated circuit, an internal state thereof is erased, excluding a nonvolatile memory. In order to restart an operation of the circuit from a state immediately before the power supply is stopped when the power supply is restarted, the internal state of flip-flops needs to be held.

A patent literature 1 discloses a technique of saving and recovering internal state of a semiconductor integrated circuit in and from a backup memory using a scan path. After the internal state is saved in the backup memory, the power supply is stopped. After the power supply is restarted, the internal state is read from the backup memory and set in a flip-flop circuit to recover the internal state.

Also, the internal state can be retained by a retention flip-flop circuit. Various methods are available for realizing the retention flip-flop circuit. For example, a retention flip-flop may be configured from a main section and a holding section. The main section requiring a high-speed operation is provided with a flip-flop including a transistor with a low threshold voltage. The holding section is provided with a flip-flop including a transistor with a high threshold voltage. Though the flip-flop in the main section has the low threshold voltage, so that the flip-flop can operate at a high speed, the flip-flop has a large leakage current. Though the flip-flop of the holding section is slow in operation, a leakage current is small. The flip-flop of the holding section is provided in the vicinity of the flip-flop of the main section. Therefore, the interconnections for the retention flip-flop are likely complicated.

Immediately before the power supply is stopped, the flip-flops of the holding section take therein data outputted from the flip-flops of the main section. While the power supply is blocked off, a circuit portion except for the flip-flops of the holding section stops the operation and the flip-flops of the holding section hold the data in a small leakage current. When the power supply is restarted, the data are outputted from the flip-flops of the holding section to the flip-flops of the main section. Thus, the data of the semiconductor integrated circuit are promptly recovered, and the semiconductor integrated circuit can restart the operation from a state immediately before the power supply is stopped,

Regards to a retention flip-flop, a technique disclosed in a patent literature 2 is known. In this technique, the retention flip-flop includes input and output nodes and two latches of a master latch and a slave latch. The latches include circuit component that are connected to the input and output nodes in serial. A first latch of the two latches holds the state of the flip-flop in a period of a power control mode when a power is disconnected from a second latch of the two latches.

When the retention flip-flop is used, a time period for restarting the operation can be shortened. However, since each of the main section and the holding section is provided with a flip-flop, the circuit area increases. Also, when the data is held in the flip-flop of the holding section, a backup power needs to be supplied. In addition, a little leakage current flows through the retention flip-flop when the flip-flop of the holding section holds the data.

Citation List:
[Patent Literature 1]: JP 2007-535031A
[Patent Literature 2]: JP 2007-157027A

### Summary of the Invention

An object of the present invention is to provide a semiconductor integrated circuit in which a leakage current can be reduced while holding an internal state thereof, and a method of saving and recovering the internal state of the semiconductor integrated circuit.

In an aspect of the present invention, a semiconductor integrated circuit includes: a first circuit; and a second circuit configured to control supply of a first power to the first circuit. The first circuit includes: a third circuit comprising a group of flip-flops, whose internal state is erased in response to stop of the supply of the first power; and a fourth circuit in which an internal state of the fourth circuit is saved in retention flip-flops before the supply of the first power is stopped and recovered from the retention flip-flops in response to restart of the supply of the first power.

In another aspect of the present invention, a method of saving and recovering an internal state is provided in a semiconductor integrated circuit includes a first circuit; and a second circuit configured to control supply of a first power to the first circuit. The method is achieved by issuing an save instruction from the second circuit to the first circuit upon entering a standby state; by saving data held by a main section in a holding section in each of retention flip-flops of the first circuit in response to the save instruction; by stopping supply of the first power by the second circuit; by erasing data stored in flip-flops and data stored in the main sections of the retention flip-flops in the first circuit in response to the stop of the supply of the first power; by restarting the supply of the first power by the second circuit in response to a recovery instruction; by recovering the data saved in the holding section of each of the retention flip-flops in the main section thereof; and by restarting an operation from a state immediately before the standby state.

In still another aspect of the present invention, a designing method is provided for a semiconductor integrated circuit which includes a first circuit; and a second circuit configured to control supply of a first power to the first circuit, wherein the first circuit includes: a third circuit configured to store internal states of the third circuit in a group of flip-flops, data held by which are erased in response to a stop of the supply of the first power; and a fourth circuit configured to store internal states of the fourth circuit in a group of retention flip-flops which data are saved before the supply of the first power is stopped and recovered in response to restart of the supply of the first power. The method is achieved by setting all of flip-flops contained in a design layer of the third circuit to be flip-flops whose data are erased in response to stop of the supply of the first power; and by setting all of flip-flops contained in a design layer of the fourth circuit to the retention flip-flops.

According to the present invention, it is possible to reduce a leakage current while holding an internal state thereof. Also, the circuit area can be made small, and interconnection workability can be improved.

### Brief Description of the Drawings

The above and other objects, advantages and features of the present invention will be more apparent from the following description of certain embodiments taken in conjunction with the accompanying drawings, in which:
FIGS. 1A to 1C are diagrams showing a power supply path in a semiconductor integrated circuit according to the present invention;
FIG. 2 is a diagram showing an internal circuit configuration of a semiconductor integrated circuit according to the embodiment of the present invention;
FIG. 3 shows timing charts in a saving and recovering operation of internal data in the semiconductor integrated circuit according to the embodiment of the present invention;
FIG. 4 is a diagram showing supply of a backup power in the semiconductor integrated circuit according to the embodiment of the present invention;
FIGS. 5A and 5B are diagrams showing prevention of propagation of an unsteady state in the semiconductor integrated circuit according to another embodiment of the present invention; and
FIG. 6 is a circuit diagram showing an example of a retention flip-flop according to the embodiment of the present invention.

### Description of Embodiments

Hereinafter, a semiconductor integrated circuit according to the present invention will be described in detail with reference to the attached drawings.

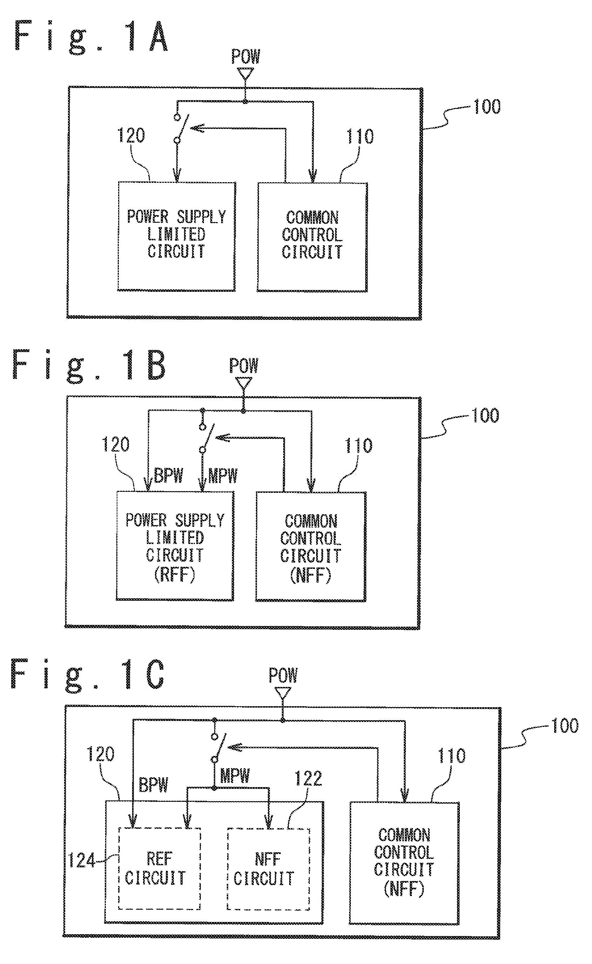

FIGS. 1A, 1B and 1C are diagrams each showing a power supply path inside a semiconductor integrated circuit to reduce a leakage current. As shown in FIG. 1A, the semiconductor integrated circuit 100 includes a power supply limited circuit 120 to which a power supply is stopped in a standby state, and a common control circuit 110 to which a power is always supplied to control the power supply to the power supply limited circuit 120. When the semiconductor integrated circuit 100 is in a standby state, the semiconductor integrated circuit 100 blocks off the power supply to the power supply limited circuit 120 in an operation stop state, and supplies the power to the common control circuit 110 so as to monitor restart of the operation. Thus, a leakage current can be reduced.

At this time, when a retention flip-flop RFF mentioned above is used as a flip-flop included in the power supply limited circuit 120, a backup power BPW must be supplied to a holding section of the retention flip-flop. Therefore, as shown in FIG. 1B, the common control circuit 110 is always supplied with a power POW and the power supply limited circuit 120 is supplied with the backup power BPW and a main power MPW, the supply of which is controlled by the common control circuit 110. The backup power BPW is supplied to the retention flip-flops RFF so that the retention flip-flops RFF hold an internal state (data) of the power supply limited circuit 120 while the supply of the main power MPW is stopped. Since the common control circuit 110 is always supplied with the power POW, a normal flip-flop NFF is used as a flip-flop for holding the internal state, that is, a flip-flop in which the held data erases upon blockade of supply of the power POW.

As described above, when the retention flip-flops are used and the power supply limited circuit 120 is in the standby state, the common control circuit 110 blocks the supply of the main power MPW to the power supply limited circuit 120 so as to reduce a leakage current in the power supply limited circuit 120. According to the present invention, the leakage current in the power supply limited circuit 120 can be further reduced. That is, the retention flip-flops are not used but normal flip-flops are used as flip-flops of circuits having no relation to an ordinary operation such as a testing circuit and a debug circuit built in the power supply limited circuit 120. As shown in FIG. 1C, the flip-flops included in the power supply limited circuit 120 are classified into two types, one is related to the ordinary operation and the other is not related to the ordinary operation. The retention flip-flops RFF are used as the flip-flops related to the ordinary operation, and a RFF circuit 124 includes such a type of flip-flops. The normal flip-flops NFF are used as the flip-flops having no relation to the ordinary operation, and a NFF circuit 122 includes such a type of flip-flops. Although two circuits of the NFF circuit 122 and the RFF circuit 124 are described, the number of circuits is not limited.

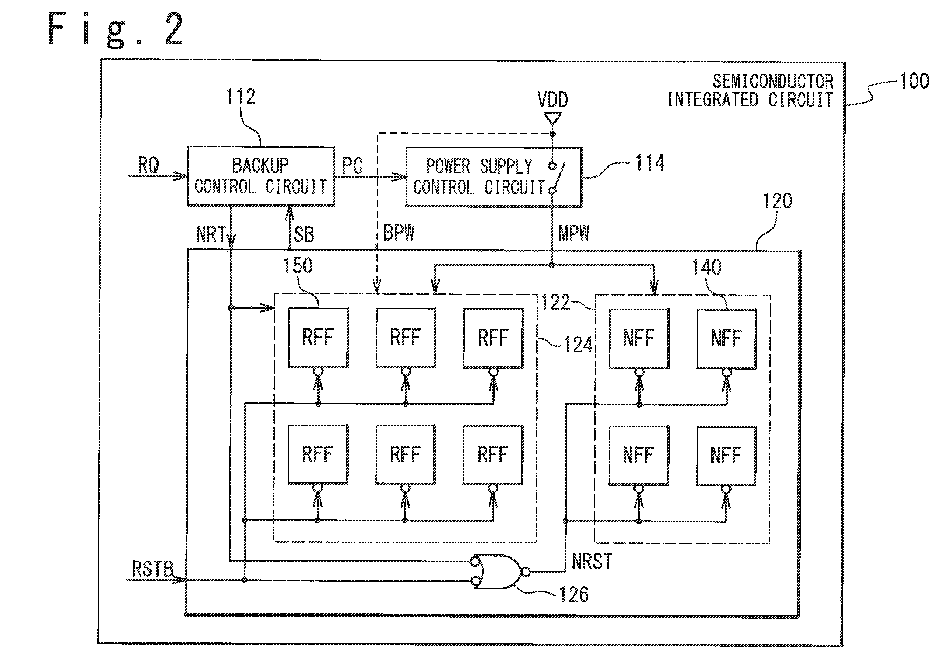

The configuration thereof will be described in more details with reference to FIG. 2. In the semiconductor integrated circuit 100, the common control circuit 110 is provided with a backup control circuit 112 and a power supply control circuit 114, and the power supply limited circuit 120 is provided with the RFF circuit 124, the NFF circuit 122 and a logic circuit 126. The power supply limited circuit 120 is preferably a circuit realizing an information processing unit such as a CPU (Central Processing Unit), which stops the operation and enter a standby state, when there is no information to be processed.

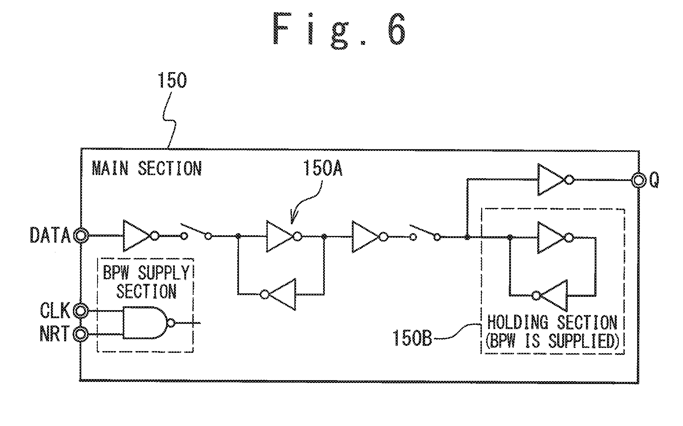

When the power supply limited circuit 120 enters the standby state, the CPU executes an instruction to output a standby indication signal SB. When the power supply limited circuit 120 enters the standby state, the backup control circuit 112 instructs the power supply limited circuit 120 to store the internal states held in main sections 150A of the retention flip-flops 150 into holding sections 150B (FIG. 6). When the storage of the internal states into the holding section is completed, the backup control circuit 112 issues a power supply control instruction PC to instruct the power supply control circuit 114 to block off the main power MPN. Further, the backup control circuit 112 detects a request for restarting an operation of the power supply limited circuit 120 based on a startup request signal RQ and issues the power supply control instruction PC to instruct the power supply control circuit 114 to turn on the main power MPW. After the main power supply MPW is turned on again and then a time elapses which is necessary to recover the internal states held in the holding section of the retention flip-flops 150, the backup control circuit 112 releases a retention control signal NRT so that the power supply limited circuit 120 restarts the ordinary operation.

The RFF circuit 124 holds the internal states of the retention flip-flops 150. Therefore, the RFF circuit 124 is supplied with the backup power BPW and the main power MPW and controlled by the power supply control circuit 114.

The NFF circuit 122 includes a circuit used for testing and debugging a circuit and does not contribute the ordinary operation of the power supply limited circuit 120. However, the NFF circuit 122 is located in the vicinity of the RFF circuit 124 used in the ordinary operation due to a condition of a delay time and so on at a time of testing or debugging the circuit. Therefore, the NFF circuit 122 is provided in the power supply limited circuit 120 together with the RFF circuit 124. The NFF circuit 122 holds the internal states of the normal flip-flops 140 that are operated at a high speed. Accordingly, the main power MPW is supplied to the NFF circuit 122, and the leakage current in the NFF circuit 122 is reduced to be zero when the supply of the main power MPW is stopped.

In this way, the number of retention flip-flops to which the backup power BPW is supplied can be decreased to reduce the consumed power in the standby state. Further, since the normal flip-flop 140 has no holding section, the circuit area thereof is smaller than that of the retention flip-flop 150. Therefore, the area of the power supply limited circuit 120 can be reduced by decreasing the number of retention flip-flops 150. Moreover, the normal flip-flop 140 does not require an interconnection for the backup power BPW, and an interconnection easiness can be improved. In particular, since the testing circuit and the debugging circuit which are severe in a delay time are located in the vicinity of the retention flip-flops 150 for use in the ordinary operation, there can be obtained a remarkable effect of decrease in the interconnections.

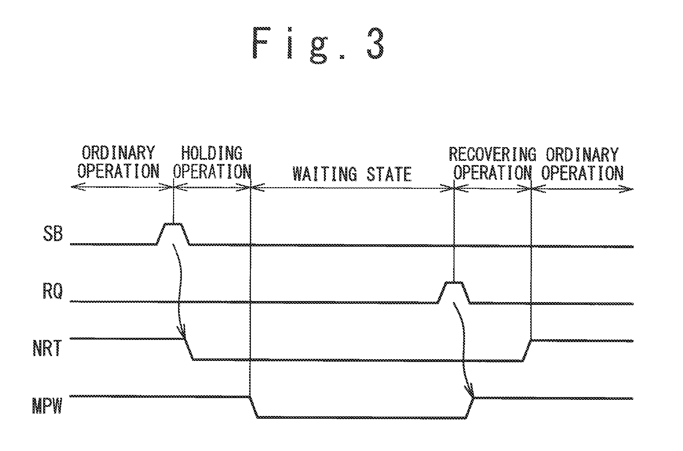

Next, a holding operation at the time of shift to the standby state and a recovering operation at the time of restart of the operation from the standby state in the semiconductor integrated circuit 100 will be described. FIG. 3 shows timing charts of the standby indication signal SB, the startup request signal RQ, the retention control signal NRT and the supply state of the main power MPW, in the ordinary operation, the holding operation, the recovering operation and the ordinary operation. In FIG. 3, in the ordinary operation period, the standby instruction signal SB and the startup request signal RQ are inactive (L), and the retention control signal is inactive (H). The main power supply MPW shown is being supplied.

When the power supply limited circuit 120 has no process to be executed and enters the standby state, an instruction is executed to activate the standby instruction signal SB (H), as shown in FIG. 3. Thus, the holding operation is started. When the backup control circuit 112 detects that the power supply limited circuit 120 enters the standby state, the backup control circuit 112 activates the retention control signal NRT to the low level (L) to instruct that the internal states of the power supply limited circuit 120 are stored in the holding sections of the retention flip-flops 150. Then, the backup control circuit 112 outputs the power supply control instruction PC to instruct the power supply control circuit 114 to block off the supply of the main power MPW. Thus, the power supply control circuit 114 stops the supply of the main power MPW. Accordingly, the power supply limited circuit 120 is supplied with only the backup power BPW and is set to the standby state with reduction of the leakage current.

The recovery operation is started when the startup request signal RQ is activated to the high level (H) in response to an external operation or through startup by a timer in FIG. 3. When the backup control circuit 112 detects a request of restarting the operation upon receipt of the startup request signal RQ, the backup control circuit 112 applies the power supply control instruction PC to instruct the power supply control circuit 114 to turn on the main power MPW. After a time lapse for recovering the internal states held in the holding section of the retention flip-flops 150 to the main sections, the backup control circuit 112 releases the retention control signal NRT. Thus, the retention control signal NRT is Inactivated to the high level (H) and the power supply limited circuit 120 restarts the ordinary operation.

A reset signal NRST generated by the logic circuit 126 is supplied to each of the flip-flops NFF 140 in the NFF circuit. 122. The reset signal NRST is a logical OR of a reset signal RSTB and the retention control signal NRT supplied to the power supply limited circuit 120. That is, the reset signal RSTB and the retention control signal NRT are signals having an active low level and when at least one of them is active (L), the reset signal NRST is active (L). Since the retention control signal NRT is active (L) immediately before the ordinary operation is restarted, each flip-flop is reset to an initial state at the time of restarting the operation and then the operation is started.

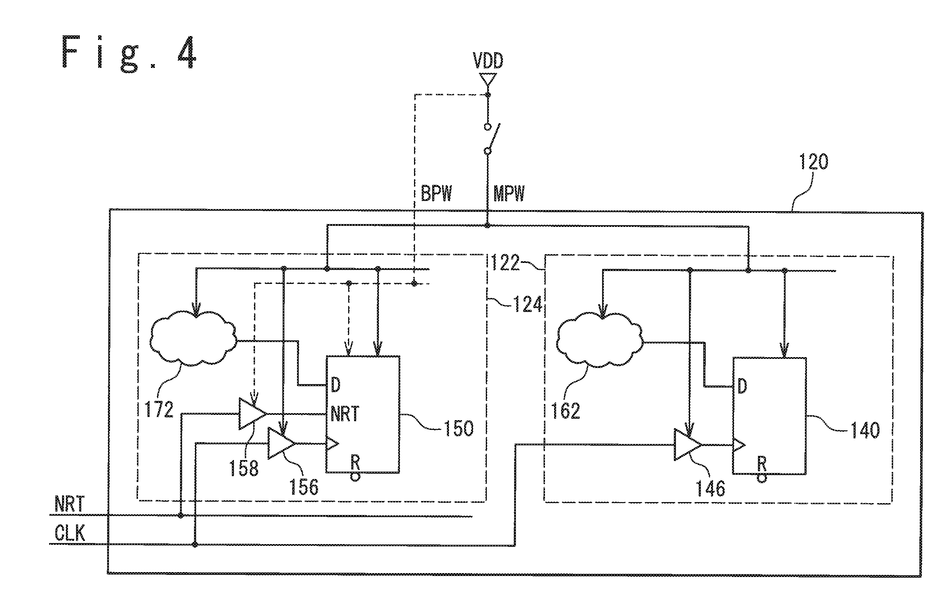

In this way, the main power MPW supplied to the power supply limited circuit 120 is blocked off and the leakage current is reduced. At this time, since the power supply to the all flip-flops 140 included in the NFF circuit 122 is stopped, there is no problem even if the power supply to be applied to a combinational circuit 162 and a buffer circuit 146 included in the NFF circuit 122 is blocked off (FIG. 4). In the RFF circuit 124, however, the retention control signal NRT connected to the retention flip-flop 150 is not allowed to be undefined even if the supply of the main power MPW is stopped. That is, if the retention control signal indicates a retention release in a period during which the power supply limited circuit 120 is in the standby state, there arises a malfunction.

Therefore, as shown in FIG. 4, it is necessary to supply the backup power BPW to a buffer circuit 158 which relays the retention control signal NRT, among the combinational circuit in the RFF circuit 124. If the retention control signal NRT is in the active state, the retention flip-flop 150 is not affected even if the other signals are undefined. For example, when the main power MPW is supplied to a combinational circuit 172 which generates an input data and a buffer 156 which relays a clock signal CLK to be supplied to the retention flip-flop 150, the internal state held in the holding section of the retention flip-flop 150 is unchanged, even if the standby state is set and the power supply is stopped.

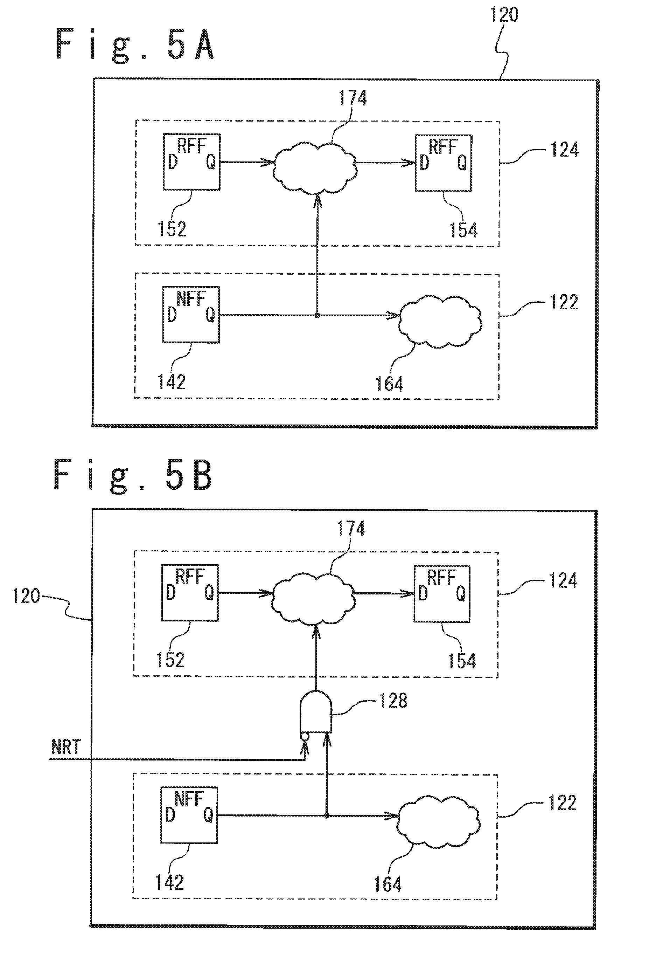

In the above description, the NFF circuit 122 is reset before restarting the operation, since the internal states of the NFF circuit 122 become undefined at the time of restart of the supply of the main power MPW. However, as shown in FIGS. 5A and 5B, a mask circuit 128 (i.e., logical AND, barrier gate) may be inserted. As shown in FIG. 5A, it is assumed that the NFF circuit 122 in the power supply limited circuit 120 includes a normal flip-flop 142 and a combinational circuit 164, and the RFF circuit 124 includes retention flip-flops 152 and 154 and a combinational circuit 174. The combinational circuit 174 receives an output of the normal flip-flop 142 and an output of the retention flip-flop 152, and outputs a logical operation result to the retention flip-flop 154. In this case, if the output of the normal flip-flop 142 is undefined, the output of the combinational circuit 174 is also undefined, and the retention flip-flop 154 cannot receive a correct result. Therefore, as shown in FIG. 5B, it is preferable that the mask circuit 128 is inserted between the normal flip-flop 142 and the RFF circuit 124 to be able to disconnect the output of the normal flip-flop 142. When the retention control signal NRT is inactive ("1"), the mask circuit 128 outputs a fixed value "0" so that the output of the flip-flop 142 is masked. The output of the flip-flop connected to the combinational circuit 174 among the retention flip-flops included in the NFF circuit 122 is masked, thereby the RFF circuit 124 can be free from an influence of the NFF circuit 122.

Although the retention control signal NRT is used as a signal for controlling the mask circuit for a brief explanation; another signal may be used. Further, as described above, by blocking off the signal to prevent the RFF circuit 124 from receiving influence of the NFF circuit 122, the power supply to the NFF circuit 122 may be blocked off at the time of ordinary operation.

As described above, according to the present invention, the flip-flops included in the power supply limited circuit 120 are classified into two groups: one is a group of first (retention) flip-flops and the other is a group of second (non-retention) flip-flops. The first flip-flops hold data indicative of the internal states, and the second flip-flops do not hold the data indicative of the internal states. The first flip-flops are flip-flops included in a circuit operable in an ordinary operation (original functioning operation) and are implemented by mapping of the retention flip-flops (RFF), The second flip-flops are flip-flops included in a circuit such as a debugging circuit and a testing circuit that does not influence on the ordinary function even if it does not operate, and are realized by mapping of the normal flip-flops (NFF).

In the non-retention flip-flops (NFF), since the held data is undefined after the restart of the power supply so that a malfunction could be caused, a circuit is added to suppress or control propagation of the undefined data from the non-retention flip-flops. This circuit is realized by a method of providing a mask circuit in a path from the non-retention flip-flops (NFF) to the RFF circuit 124 including the retention flip-flops (RFF) to block off the undefined signals, or a method of providing a reset circuit to reset only the non-retention flip-flops (NFF) after the restart of the power supply.

The mask circuit is preferably inserted to only a path through which a signal influencing the RFF circuit 124 flows. Also, in order to reduce leakage current in the NFF circuit 122 at the time of the supply of power, the power supply to the NFF circuit 122 may be blocked off in the ordinary operation. In this case, it is preferable that power supply structures of the RFF circuit 124 and the NFF circuit 122 are separated from each other and barrier gates are inserted in all of the paths between the RFF circuit 124 and the NFF circuit 122.

When a circuit using the retention flip-flops and a circuit using the normal flip-flops are classified based on the function, the circuit for realizing an original function is provided with the retention flip-flops, and the testing circuit and the debugging circuit are provided with normal flip-flops. When a circuit is hierarchically designed, the designing layers are different at the time of designing the circuit between the circuit for realizing the original function and the testing and debugging circuits. Therefore, if the normal flip-flops or the retention flip-flops are used for every circuit depending on the designing layer, the circuit division can be performed.

As described above, since the flip-flops mapped to the retention flip-flops can be limited to rlip-flops realizing the ordinary function and the testing circuit and the debugging circuit can be excluded, the number of retention flip-flops can be reduced. Therefore, the circuit area of the flip-flops can be made smaller and the leakage current can be suppressed. Further, the interconnection easiness can be improved. Although the retention flip-flop is described, as a type of a circuit requiring a backup power as shown in FIG. 6, another type of a circuit using a magnetic substance or a ferrodielectric substance that does not require the backup power may be also adapted similarly.

Although the present invention has been described above in connection with several embodiments thereof, it would be apparent to those skilled in the art that those embodiments are provided solely for illustrating the present invention, and should not be relied upon to construe the appended claims in a limiting sense.

## Claims

1. A semiconductor integrated circuit comprising:
a first circuit; and
a second, circuit configured to control supply of a first power to said first circuit,
wherein said first circuit comprises:
a third circuit comprising a group of flip-flops, whose internal state is erased in response to stop of the supply of said first power; and
a fourth circuit in which an internal state of said fourth circuit is saved in retention flip-flops before the supply of said first power is stopped and recovered from said retention flip-flops in response to restart of the supply of said first power.

2. The semiconductor integrated circuit according to claim 1, wherein each of said retention flip-flops comprises:
a main section supplied with said first power and configured to hold a data during the supply of said first power; and
a holding section configured to hold the data in said main section before the supply of said first power is stopped,
wherein the data held in said main section is saved in said holding section immediately before the supply of said first power is stopped and recovered in said main section immediately after the supply of said first power is restarted.

3. The semiconductor integrated circuit according to claim 2, wherein said holding section is supplied with a second power to hold the data form said main section.

4. The semiconductor integrated circuit according to claim 1, wherein each of said retention flip-flops comprises:
a main section supplied with said first power and configured to operate faster than a transistor with a low threshold; and
a holding section supplied with a second power, having a leakage current less than a transistor with a high threshold, and configured to hold a data held in said main section when the supply of said first power is stopped,
wherein the data held in said holding section is recovered in said main section when the supply of said first power is restarted.

5. The semiconductor integrated circuit according to any of claims 1 to 4, wherein said third circuit is reset when the supply of said first power is restarted.

6. The semiconductor integrated circuit according to any or claims 1 to 4, wherein said first circuit further comprises:
a mask circuit provided for each of signal paths from said third circuit to said fourth circuit,
said mask circuit masks to prevent data in said third circuit from being propagated to said fourth circuit after the supply of said first power is restarted.

7. A method of saving and recovering an internal state in a semiconductor integrated circuit which comprise a first circuit; and a second circuit configured to control supply of a first power to said first circuit, said method comprising:
issuing an save instruction from said second circuit to said first circuit, upon entering a standby state;
saving data held by a main section in a holding section in each of retention flip-flops of said first circuit in response to the save instruction;
stopping supply of said first power by said second circuit;
erasing data stored in flip-flops and data stored in said main sections of said retention flip-flops in said first circuit in response to the stop of the supply of said first power;
restarting the supply of said first power by said second circuit in response to a recovery instruction;
recovering the data saved in said holding section of each of said retention flip-flops in said main section thereof; and
restarting an operation from a state immediately before said standby state.

8. The method according to claim 7, further comprising:
resetting said flip-flops in response to the restart of the supply of said first power.

9. The method according to claim 7 or 8, further comprising:
masking data outputted from said flip-flops to prevent the data from being propagated to said retention flip-flops.

10. A method of designing a semiconductor integrated circuit which comprises:
a first circuit; and
a second circuit configured to control supply of a first power to said first circuit,
wherein said first circuit comprises:
a third circuit comprising a group of flip-flops, whose internal state is erased in response to stop of the supply of said first power; and
a fourth circuit in which an internal state of said fourth circuit is saved in retention flip-flops before the supply of said first power is stopped and recovered from said retention flip-flops in response to restart of the supply of said first power.
said method comprising:
setting all of flip-flops contained in a design layer of said third circuit to be flip-flops whose data are erased in response to stop of the supply of said first power; and
setting all of flip-flops contained in a design layer of said fourth circuit to said retention flip-flops.
